Europäisches Patentamt

(19) European Patent Office

Office européen des brevets

(11) Publication number: **0 140 768**
A2

(12) # EUROPEAN PATENT APPLICATION

(21) Application number: **84401997.6**

(22) Date of filing: **05.10.84**

(51) Int. Cl.⁴: **G 11 C 8/00**, G 11 C 11/24, G 11 C 11/40

(30) Priority: **07.10.83 JP 186930/83**

(43) Date of publication of application: **08.05.85**
**Bulletin 85/19**

(84) Designated Contracting States: **DE FR GB**

(71) Applicant: **FUJITSU LIMITED, 1015, Kamikodanaka Nakahara-ku, Kawasaki-shi Kanagawa 211 (JP)**

(72) Inventor: **Okajima, Yoshinori, 1-2, Fujigaoka 2 Chome Midori-ku, Yokohama-shi Kanagawa 227 (JP)**

(74) Representative: **Descourtieux, Philippe et al, CABINET BEAU de LOMENIE 55 rue d'Amsterdam, F-75008 Paris (FR)**

(54) **A semiconductor memory device.**

(57) A bipolar static memory device comprising clamping circuits (Q6) to sustain the potential on the word lines (WL₊) in non-selected state at a specified level is disclosed. Each of the high potential side word lines (WL₊) is connected to a clamping circuit (Q6) formed from a pnpn transistor whose base is supplied with a reference voltage (V_{R2}) and whose emitter and collector are respectively connected to the word line (WL₊) and a high potential source (V_{CC}). Each of the word lines is clamped at a common level slightly higher than the level determined by the output voltage of each associated word driver gate (20) in non-selected state, hence, the potential on the word lines in non-selected state can be uniform throughout the memory device regardless of the nonuniformity of the values of the resistors (R1) in the word driver gates (20).

EP 0 140 768 A2

1

## TITLE OF THE INVENTION
### A SEMICONDUCTOR MEMORY DEVICE
### BACKGROUND OF THE INVENTION

The present invention relates to a semiconductor memory device, in particular, to a semiconductor memory device provided with a function to reduce the potential fluctuation on each of the word lines and the potential nonuniformity among the word lines during non-selected state.

In the access to a semiconductor memory device such as a bipolar static random access memory, for example, a word line in selected state is brought to a high level potential (referred to as selected level, hereinafter), and then, the write-in or read-out of data in a memory cell connected to the word line is carried out. On the other hand, each of the word lines in non-selected state is at a low level potential (referred to as non-selected level, hereinafter), and thus, the data stored in the memory cells connected to the non-selected word lines are sustained and preserved from the overlay by the data to be written in a memory cell connected to a different word line in selected state.

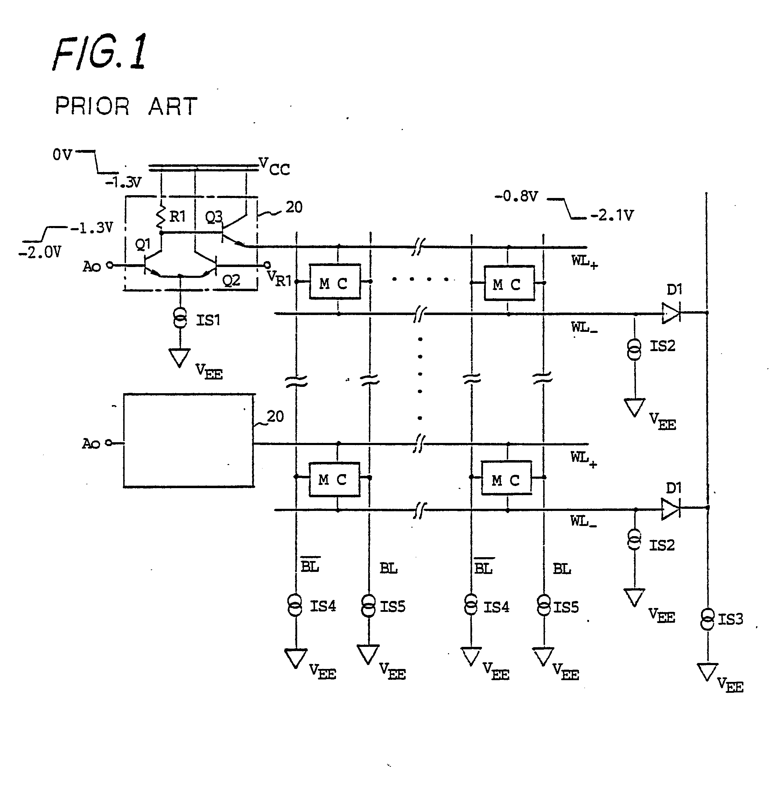

Fig. 1 is a partial circuit diagram of a conventional bipolar static random access memory. The memory device comprises memory cells MC, word lines, which include high potenital side word lines $WL_+$ and low potential side word lines $WL_-$, and word line selecting circuits 20, each connected to a respective one of the word lines $WL_+$. Each of the memory cells MC has two pairs of terminals, one of the pairs being connected between the high potential side word line $WL_+$ and the low potential side word line $WL_-$, and the other one of the pairs being connected between the bit lines denoted by $\overline{BL}$ and BL.

Each of the word line selecting circuits 20 comprises a word driver gate and a word driver. Transistors Q1 and Q2 constitute the word driver gate in the form of a differential amplifier. The word driver gate constitutes a part of an address decoder. The reference voltage $V_{R1}$ is for determining the threshold level for the word address signals Ao supplied to the word driver gate. A transistor Q3 having an emitter connected to the high potential side word line $WL_+$ constitutes the word driver.

The constant current circuit IS1 regulates the current flow through an associated resistor R1 in each word line selecting circuit 20. Constant current circuits IS2 are respectively connected between the low potential side word lines $WL_-$ and the negative potential source $V_{EE}$, and diodes D1 are respectively connected between the low potential side word lines $WL_-$ and the negative potential source $V_{EE}$ via a constant current circuit IS3 which is common for all diodes D1. The function of each diode D1 is to accelerate the discharge of charges in the parasitic capacity of the associated high potential side word line $WL_+$ during the transition from the selected state to the non-selected state of the word line $WL_+$. Constant current circuits IS4 are respectively connected between the bit lines $\overline{BL}$ and the negative potential source $V_{EE}$ and constant current circuits IS5 are respectively connected between the bit lines BL and the negative potential source $V_{EE}$.

In Fig. 1, for the purpose of simplicity, one transistor Q1 is illustrated to stand for the plurality of transistors which are connected in parallel to one another to constitute a word driver gate having a number of input terminals equal to the number of parallel bits in each words address signal Ao. Each of the memory cells MC is in the form of a flip-flop circuit similar to that used in a conventional static memory device.

In the memory device of Fig. 1, when the word address signal Ao turns to a low level such as -2.0 volts, for instance, which level is lower than the reference voltage $V_{R1}$, the associated transistor Q1 is turned off, and its collector potential takes a high level nearly equal to the level of the positive potential source $V_{CC}$, which is 0 V, for instance. As a result, a voltage of select level, -0.8 volt with respect to $V_{CC}$, for instance is applied to the high potential side word line $WL_+$ connected to the emitter of the associated word driver transistor Q3. During the period wherein a word line is in the selected state, if the potential on either bit line $\overline{BL}$ or BL of the selected couple is lowered to a predetermined low level by means of a read-write control circuit (not shown), a data corresponding to the level of the bit line is written in the flip-flop circuit of a memory cell MC connected to the subject word line $WL_+$ and bit line $\overline{BL}$ or BL. On the other hand, the data stored in the memory cell MC connected to a word line in selected state is read out by detecting the potential or current on the associated bit line $\overline{BL}$ or BL by means of a sense amplifier (not shown).

When a high potential side word line $WL_+$ is in selected state, the potential on the associated low potential side word line $WL_-$ also becomes higher than that of other low potential side word lines $WL_-$ which are in non-selected state. This is because the potential on the word line $WL_-$ is spontaneously kept at a level lower by a certain voltage, about 0.8 volt, for example, than the potential on the associated high potential side word line $WL_+$. Therefore, the potentials on the word lines $WL_+$ and $WL_-$ change concurrently while keeping a potential difference of about 0.8 volt. As a result, only the diode D1 connected to the word line $WL_-$ in selected state is in ON state, while the diodes D1

connected to other low potential side word lines $WL_-$ in non-selected state are kept in OFF state.

Since the constant current circuit IS3 has a large current capacity compared with the constant current circuit IS2, a large portion of the current from the high potential side word line $WL_+$ trhough the memory cell MC to the low potential word line $WL_-$ flows into the common constant current circuit IS3 as far as the diode D1 remains in the ON state. Thus, the diode D1 operates to accelerate the discharge of the charges in the parasitic capacity attached to the associated high potential side word line $WL_+$, and therefore, a rapid transition from the selected state to the non-selected state of the word lines $WL_+$ can be performed.

When the w o r d   address signal Ao turns to a high level such as -1.3 volts, for instance, which level is higher than the reference voltage $V_{R1}$, the associated transistor Q1 turns ON and its collector potential takes a low level, -1.3 volts, for instance. As a result, the emitter potential on the associated word driver transistor Q3, namely, the potential on the high potential side word line $WL_+$ is lowered to the level, -2.1 volts, which is lower than the base potential (-1.3 volts) of the transistor Q3 by the base-emitter voltage of about 0.8 volt, and thus, the word line $WL_+$ becomes in non-selected state. In this state, although the associated diode D1 eventually turns to the OFF state, the current from the high potential side word line $WL_+$ through the flip-flop circuits in the memory cells MC connected to the word line $WL_-$ to the low potential side word line $WL_-$ is maintained by the associated constant current circuit IS2, and, the data stored in the memory cells are retained.

In the conventional memory device shown in Fig. 1, the potential on the high potential side word line $WL_+$

in non-selected state is determined by the collector potential of the transistor Q1, this collector potential depending on the resistor R1 and the collector current of the transistor Q1. Therefore, the collector potential of Q1 is lower than the level of the positive potential source $V_{CC}$ by the potential drop across the resistor R1. However, due to the dispersion in the manufacturing process of the memory device, it is in general difficult to obtain resistors R1 with identical values. It is also difficult to build the constant current circuits IS1 in the semiconductor memory with a uniform current characteristic, also because of the dispersion of the values of the internal resistors included in the constant current circuits. Therefore, the value of the resistors R1 and the collector current of the transistor Q1 cannot be uniform throughout the chip. As a result, the potentials on the word lines in non-selected state are likely to be different from one word line to another word line in the memory device.

Reminding that the potentials on the word lines $WL_+$ and $WL_-$ in selected state are determined by the $V_{BE}$, base-emitter voltage, of the transistor Q3, the amplitude of potential on the word lines, namely, the potential changes of the word lines between the selected state and the non-selected state, should differ from one word line to another due to the nonuniformity of the value of the resistors R1 and of the characteristics of the constant current circuits IS1.

This phenomenon reduces the margin of the negative potential $V_{EE}$ supplied for the constant current circuits IS2, and eventually requires a large value for the negative potential $V_{EE}$. However, a large $V_{EE}$ results in an increase in the power consumption of the memory device.

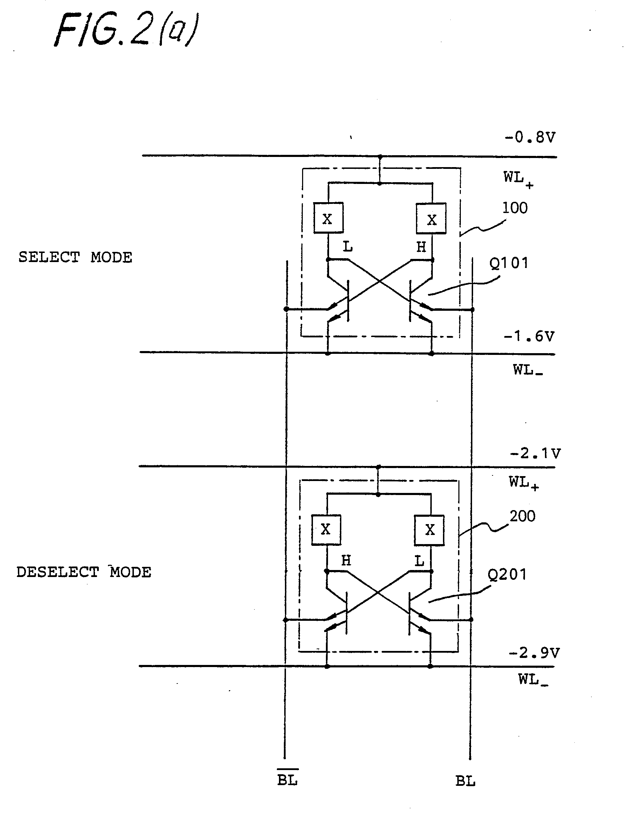

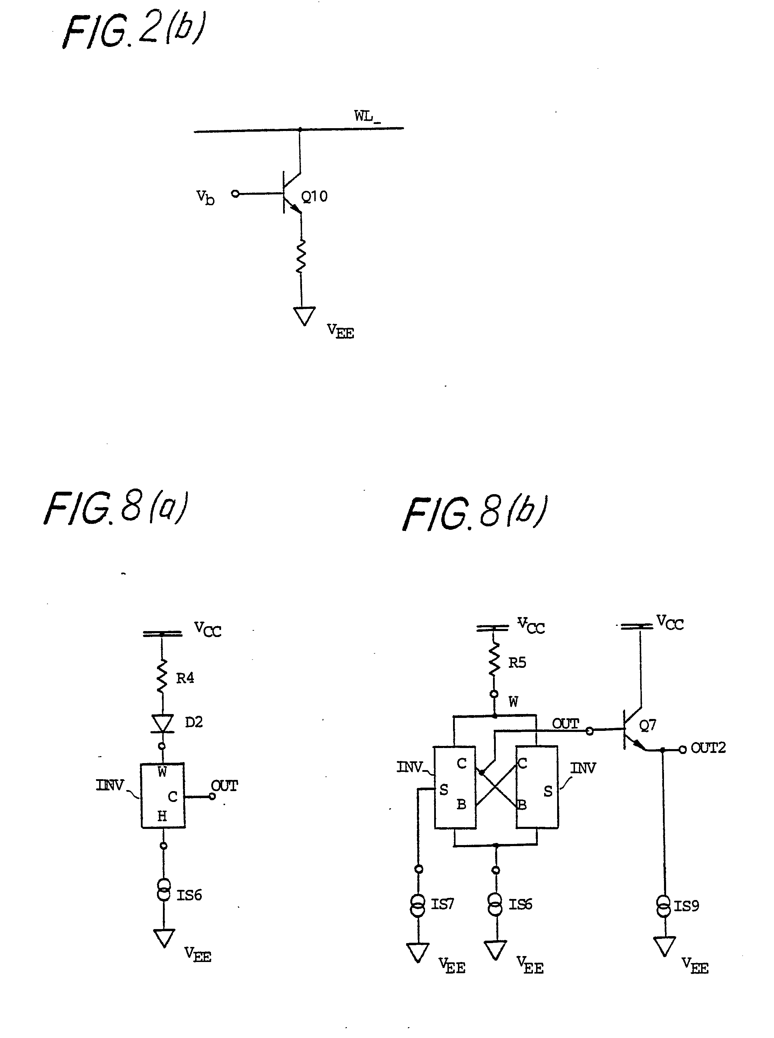

Another problem arising from the nonuniformity of the potentials on the word lines in non-selected state resides in the large loss of the write-in current, flowing along a selected bit line. Fig. 2(a) is a partial circuit diagram of a memory device including flip-flop type memory cells 100 and 200, wherein the potentials on the word line $WL_+$ to which the memory cell 100 is connected is raised to the select level (-0.8volt), and the memory cell 100 is in selected state, while the memory cell 200 is kept in non-selected state because the potential on the word line $WL_+$ to which the memory cell 200 is connected is at the deselect level (-2.1 volts). When the potential on the bit line BL is lowered to write a data into the memory cell 100, the potential on the base of the transistor Q101 of the cell 100, which is initially at a low level (L; approximately -1.6 volts), is eventually turned to a high level (H; approximately -0.8 volt). In Fig. 2(a), the reference character X denotes a load impedance.

If the potential on the gate of the transistor Q201 of the cell 200 is at a high level (H; approximately -2.1 volts), the write-in current flowing along the bit line BL is composed of the emitter currents of the transistor Q101 and Q201. The emitter current Ie of a transistor is given by the formula

$$Ie = Is \cdot \exp(qV_{BE}/kT) \ldots \ldots \ldots \ldots (1),$$

where Is and $V_{BE}$ are the saturation current and base-emitter voltage of the transistor, respectively.

Referring back to Fig. 2(a), the ratio of the emitter current ($Ie_2$) of the transistor Q201 to the emitter current ($Ie_1$) of the transistor Q101 is given by the formula

$$Ie_2/Ie_1 = \exp/(-q/kT) \Delta V_{BE}/ \ldots \ldots \ldots (2),$$

where $\Delta V_{BE}$ is the difference between the respective base-emitter voltages $V_{BE}$ of the transistors Q101 and Q201. According to the formula (2), with every 60 mV decrease of the $V_{BE}$ of the transistor Q201 with respect to the $V_{BE}$ of the transistor Q101, the emitter current ratio $Ie_2/Ie_1$ decreases by a factor of ten.

In a 4-kbit RAM (Random Access Memory), for example, 64 memory cells can be connected to a bit line, with one in the selected state and the remainder 63 in the non-selected state. Accordingly, the current along the bit line effectively used for the write-in operation of the selected memory cell is only about 60 per cent, in the worst (wherein the flip-flop circuits of the 63 memory cells in non-selected state are latched to be in the same polarity as shown in Fig. 2(a) , even when a $\Delta V_{BE}$ of about 120 mV is provided between the transistor in the selected memory cell and the transistors in the memory cells in non-selected state. As a result, referring again to Fig. 2(a), it is requested that a $\Delta V_{BE}$ of more than 200 mV should be given between the transistors Q101 in the memory cells in selected state and the transistor Q201 in each of the memory cells in non-selected state, if the memory device has a capacity of 16 kbits or more.

The potential difference of 0.5 volt between the low potential side word line $WL_-$ in selected state (-1.6 volt) and the high potential side word line $WL_+$ in non-selected state (-2.1 volt) is determined according to the above discussion, that is, represents the total of the 200 mV for the requested $\Delta V_{BE}$ and the margin of 300mV for the potential dispersion among the word lines $WL_+$ due to the aforementioned nonuniformity of the values of the resistors R1 and so forth. However, 0.5 volt is a minimum and not sufficient for a conventional semiconductor memory device having a capacity around 16 kbits or more when taking the potential fluctuation of the power source into consideration.

By increasing the value of the resistor R1, a potential difference larger than 0.5 volt could be

8

provided, however, the larger the value of the resistor R1, the larger the fluctuation and dispersion of the word line potentials.

Another serious problem, which makes it impossible to increase the value of the resistor R1, arises in connection with the operational margin of each constant current circuit IS2.

Referring to Fig. 2(b), which is an exemplary circuit diagram of the constant current circuit IS2, a bias voltage $V_b$ of 1.2 volts is applied to the base of the transistor Q10 with respect to the negative potential source $V_{EE}$. Therefore, if the value of the negative potential $V_{EE}$ is -4.2 volts and the potential on the word line WL_ in non-selected state is -2.9 volts, the base-collector voltage $V_{BC}$ of the transistor Q10 is 0.9 volt, which is larger than the base-emitter voltage $V_{BE}$ (0.8 volt) by only 0.1 volt. It is required, in general, that $V_{BC}$ is larger than $V_{BE}$, so as to make the constant current circuit as shown in Fig. 2(b) keep its function. Accordingly, to increase the value of the resistors R1 does not any longer appear to be practical for increasing the aforementioned potential difference of 0.5 volt.

In other words, if the potential dispersion among the word lines $WL_+$ can be reduced, the potential difference 0.5 volt would be enough to operate higher integration density memory device, such as 16-kbit RAMs, or it would be possible to take advantage of the setting of the negative potential $V_{EE}$ at a higher level, thereby reducing power consumption of the memory device, or of the operation of the constant current circuits IS2 with a larger operational margin.

SUMMARY OF THE INVENTION

Therefore, it is an object of the present invention to provide a semiconductor memory device in which the potential on the word lines in non-selected state is stabilized and made uniform throughout the memory device.

It is another object of the present invention to provide a semiconductor memory device in which the operational margin of each current source for sustaining the data stored in a memory cell in non-selected state is increased.

It is still another object of the present invention to provide a semiconductor memory device wherein the efficiency of the write-in current through a selected bit line is improved.

The above objects can be accomplished by providing a semiconductor memory device comprising : a plurality of memory cells ; a plurality of word lines each connected to said memory cells; a plurality of word line selecting circuits each connected to a respective one of the word lines and providing the associated word line with a selection potential when the associated word line is selected; and a plurality of clamping circuits each connected to a respective one of said word lines and maintaining the potential on the associated word line at a predetermined deselect level when said associated word line is in non-selected state.

The word line selecting circuit comprises a word driver gate and a word driver and constitutes a portion of an address decoder. The clamping circuit comprises a transistor having a base to which a reference voltage is applied and an emitter connected to the associated word line.

According to the present invention, the potential on the word lines in non-selected state is forced to be at a predetermined level, and thus, is made stable and uniform throughout the semiconductor memory chip.

These together with other features and advantages of the present invention will become apparent from the reading of the description of various embodiments of a semiconductor memory device according to the invention. Reference will be made to the accompanying Figures wherein same reference characters are used to denote similar parts throughout the drawings.

BRIEF DESCRIPTION OF THE DRAWINGS

Fig. 1 is a partial circuit diagram of a conventional bipolar static random access memory;

Fig. 2(a) is a partial circuit diagram of a memory device including flip-flop type memory cells;

Fig. 2(b) is a circuit diagram of an exemplary constant current circuit used in a semiconductor memory device;

Fig. 3 is a partial circuit diagram illustrating an embodiment of a semiconductor memory device according to the present invention;

Fig. 4 is a partial circuit diagram illustrating another embodiment of a semiconductor memory device according to the present invention;

Fig. 5 is a partial circuit diagram illustrating further another embodiment of a semiconductor memory device according to the present invention;

Fig. 6(a) is a conceptual block diagram showing the configuration of an ordinary static memory cell;

Figs. 6(b), 6(c) are circuit diagrams each showing an exemplary detailed configuration of a conventional static memory cell;

Figs. 7(a), 7(b), 7(c), 7(d) and 7(e) are circuit diagrams showing exemplary reference voltage generation circuits; and

Figs. 8(a) and 8(b) are circuit diagram showing further exemplary reference voltage generation circuits.

PREFERRED EMBODIMENT OF THE INVENTION

In the following figures used to illustrate embodiments of the present invention, only one memory cell and each couple of the associated word lines $WL_+$ and $WL_-$

and bit lines $\overline{BL}$ and BL are illustrated together with a corresponding word line selecting circuit and a corresponding clamping circuit, for the purpose of simplicity, and same reference characters are used to designate same or corresponding elements in these figures and in the precedent figures.

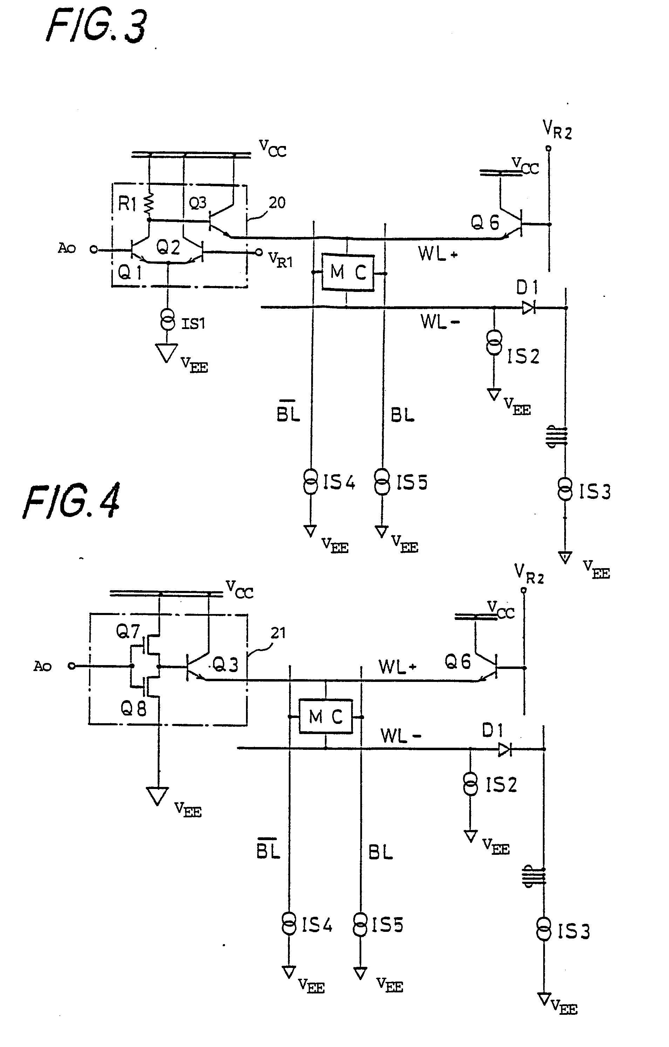

Fig. 3 is a partial circuit diagram illustrating an embodiment of a semiconductor memory device according to the present invention. In the memory device shown in Fig. 3, a transistor Q6 forms a clamping circuit and is connected to the high potential side word line $WL_+$. The emitter and the collector of the transistor Q6 are respectively connected to the associated word line $WL_+$ and the high potential source $V_{CC}$. The base of the transistor Q6 is connected to the reference voltage source $V_{R2}$ which is common throughout the semiconductor memory device.

In the circuit shown in Fig. 3, the level of the reference voltage $V_{R2}$ is set slightly higher than the low level of the output of the word driver gate comprising the transistors Q1 and Q2, namely, the collector voltage of the transistor Q1. If the low level of the collector voltage of the transistor Q1 is -1.3 volts, as shown in Fig. 1, the reference voltage $V_{R2}$ is set at -1.0 volt, for example. Under this condition, in non-selected state, the potential on the high potential side word line $WL_+$ is determined by the reference voltage $V_{R2}$ and the base-emitter voltage (0.8 volt) of the transistor Q6. Thus, the word line $WL_+$ is clamped at the level of -1.8 volts. This because the transistor Q3 cannot keep its base-emitter voltage of 0.8 volt any longer, and is cut-off. As a result, the word line $WL_+$ in non-selected state is not affected by the output voltage of the word driver, namely the output of the word line selecting circuit 20.

In selected state, the potential on the word line $WL_+$ is determined by the high level of the output of the word driver gate (approximately 0 volt) and the base-emitter voltage (0.8 volt) of the word driver transistor Q3, and therefore, it becomes -0.8 volt, for instance, as in the conventional memory device described with respect to Fig. 1. Under this condition, it is obvious that the clamping transistor Q6 is cut-off because it cannot keep its base-emitter voltage larger than 0.8 volt.

As previously mentioned, the value of the resistor R1 cannot be increased in a conventional semiconductor memory device, though such increase could provide some advantages for the semiconductor memory devices having higher integration density such as 16 kbits per chip or more. However, in the memory device according to the present invention, if the reference voltage $V_{R2}$ is set at -1.3 volts, the potential on the word line in non-selected state is clamped at -2.1 volts. In this case, the value of the resistor R1 can be increased enough to maintain the condition that the collector voltage of the transistor Q1 is lower than $V_{R2}$, without resulting in the above described problems that could appear in the conventional memory device. Thus, the influence of the nonuniformity of the value of the resistors R1 can be avoided, and therefore, the word line potential during non-selected state can be stabilized and made uniform throughout the memory device.

As explained above, in the memory device shown in Fig. 3, the potential on the high potential side word line $WL_+$ in non-selected state is determined by the $V_{BE}$ of the clamping transistor Q6 and the reference voltage $V_{R2}$, and is not affected by the characteristic dispersion of the components constituting the word line selecting circuit. Therefore, the operational margin of the constant current circuits IS2 and the efficiency of the write-in current on a bit line can be kept at a high level.

Fig. 4 is a partial circuit diagram illustrating
another embodiment of the semiconductor memory device
according to the present invention. The memory device
shown in Fig. 4 is almost same as the device shown in
Fig. 3, except in that the word driver gate in the word
line selecting circuit 21 is formed from CMOS (Complementary Metal Oxide Semiconductor) transistors. For
the purpose of simplicity, a CMOS gate comprising a
p-channel MOS transistor Q7 and an n-channel MOS transistor Q8 is shown to stand for entire word driver gate
circuit having a CMOS configuration.

In the memory device as shown in Fig. 4, the output level of the word driver gate, namely, the CMOS
inverter comprising the transistors Q7 and Q8, changes
between a high level almost equal to the level of the
positive potential source $V_{CC}$ and a low level approximately equal to the level of the negative potential
source $V_{EE}$. Therefore, the potential on the word lines $WL_+$
in non-selected state is forced to fall to the level
around $V_{EE}$. However, according to the present invention,
the word line potential on each $WL_+$ in non-selected state
is kept at the level determined by the clamping circuit
comprising transistor Q6 and the reference voltage $V_{R2}$.
When the reference voltage $V_{R2}$ is set at -1.3 volts,
for example, the potential on the word line $WL_+$ in non-
selected state is clamped at the level -2.1 volts, which
is high enough for the memory cells in non-selected
state to sustain the data in them. At this time, the
potential on the word line $WL_-$ in non-selected state
is -2.9 volts, which is alo high enough for the associated
current circuit IS2 to keep its function.

It is well known that such CMOS configuration
is beneficial for reducing power consumption in a semiconductor device, and thus, by incorporating such clamping circuit of the present invention, a memory device having address decoders of CMOS configuration can be substantiated.

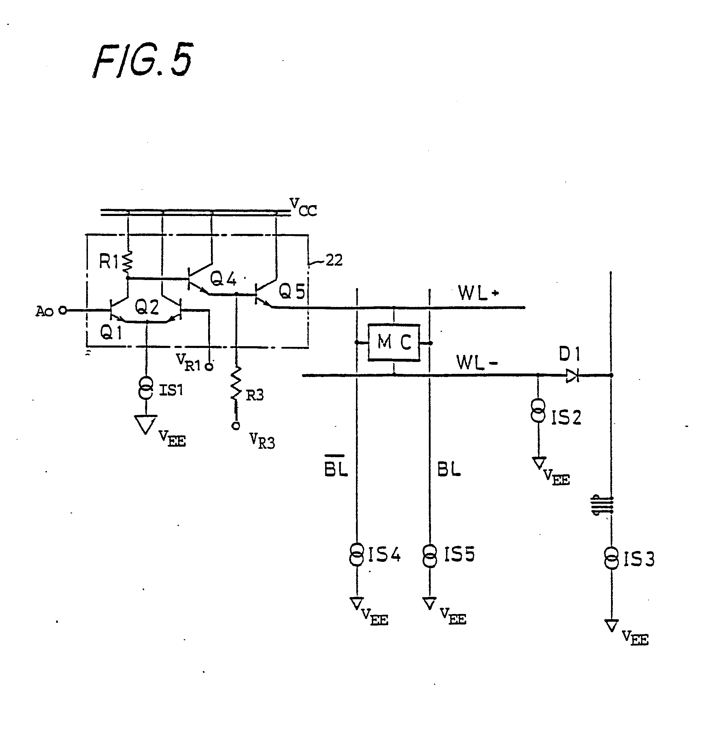

Fig. 5 is a partial circuit diagram illustrating further another embodiment of the present invention. In the memory device shown in Fig. 5, the word driver in each word line selecting circuit 22 comprises transistors Q4 and Q5, which are connected each other to form a so-called Darlington coupling. That is, the transistor Q4 whose base forms the input terminal is connected through its emitter to the base of the transistor Q5 and the emitter of the transistor Q5 forms the output terminal. A reference voltage source $V_{R3}$ is connected at the node of the transistors Q4 and Q5 via a load resistor R3. In the ordinary Darlington coupling, a transistor is provided instead of the resistor R3 in order to form a current path between the base and emitter of the transistor Q5, thus preventing the transistor Q5 from overdrive due to an excess of base current supplied by the transistor Q4.

The Darlington coupling is advantageous for improving the access time of a memory device, because it can supply the associated word line $WL_+$ with a large amount of current with a high rise time. In conventional memory devices having word line selecting circuits each comprising such Darlington coupling word driver, the above mentioned problems due to the nonuniformity of the value of the resistors Rl also exist.

On the contrary, in the memory device shown in Fig. 5, the potential on each word lines $WL_+$ in non-selected state is clamped at the level determined by the reference voltage $V_{R3}$. That is, in non-selected state, with the input of a high level word address signal Ao, the transistor Q4 turns OFF because its base voltage is turned to a low level, -1.3 volts, for example, with respect to $V_{CC}$, hence the current flowing into the resistor R3 from the transistor Q4 is negligible. Consequently, the base voltage of the transistor Q5 is $V_{R3}$, and hence, the potential on the word line $WL_+$ is at the level given by $V_{R3}$ - 0.8 volts. While, in selected state, the base voltage of the transistor Q4 is at a level nearly equal to $V_{CC}$ and that of the transistor Q5 becomes -0.8 volt with respect to $V_{CC}$. As a result, the potential on the word line $WL_+$ in selected state is at a level of -1.6 volts with respect to $V_{CC}$. In this situation, a current flows from transistor Q4 to the resistor R3, which current generates a potential drop across the resistor R3, and the base voltage of the transistor Q5 is kept higher than $V_{R3}$.

The potential change on the word line (i.e. amplitude, U, of the word line potential) during the transition between selected state and non-selected state of the memory device shown in Fig. 5 is given by

$$U = |V_{R3} - V_{CC} + 0.8| \text{ (volts)} \dots\dots\dots (3).$$

Therefore, to provide each of the word lines with a same potential swing as in the precedent embodiments, for example, 1.3 volts, $V_{R3}$ must be -2.1 volts with respect to $V_{CC}$. As a result, the potentials on the word lines $WL_+$ and $WL_-$ in non-selected state are -2.9 volts and -3.7 volts, respectively, with respect to $V_{CC}$. This suggests that the word line selecting circuit comprising a Darlington coupling configuration word driver requires larger negative potential $V_{EE}$ compared with the word line selecting circuits as shown in Figs. 3 and 4. However, in the embodiment of the present invention shown in Fig. 5, the necessary amplitude of the word line potential can be reduced to about 1.0 volt, and hence $V_{R3}$ is -1.8 volts, because the aforementioned potential difference of 0.5 volt between low potential side word line in selected state and high potential side word line in non-selected state can be reduced to 0.2 volt. Accordingly, the most negative potential on the word line can be at -3.4 volts and the negative potential source $V_{EE}$ may be higher than in conventional memory device having Darlington-coupling type word driver.

This is because the clamping circuit comprising the transistor Q5 and resistor R3 eliminates the influence of the word line potential dispersion due to the nonuniformity of the value of the resistors R1, and thus, the increase of power consumption in a semiconductor memory device of higher speed and integration density can be reduced. Moreover, it should be noted that in the memory device shown in Fig. 5, the fall time of the word line potential in the transition from selected state to non-selected state is reduced, because the base voltage of the transistor Q5 is rapidly decreased to the level of $V_{R3}$ as soon as the transistor Q4 is caused to cut off.

It is obvious that a clamping circuit as shown in Figs. 3 and 4 can be effectively provided for each of the word lines in a memory device having word drivers of conventional Darlington coupling configuration as mentioned above and the same results described with reference to the embodiment of Fig. 5 can be obtained. And also, it should be noted that the reference voltage source $V_{R2}$ or $V_{R3}$ in the above embodiments can be common to all clamping transistors (Q6 in Figs. 3 and 4, or Q5 in Fig. 5) throughout a memory device. This is advantageous for enhancing the uniformity of the potential of the word lines $WL_+$ in non-selected state.

The present invention does not lie in the sources of the reference voltages used in the above embodiments. However, each of such reference voltage sources $V_{R2}$ and $V_{R3}$ can be formed of a dummy cell which has characteristics similar to that of the memory cells MC constituting the memory device, this being preferable for the manufacturing of the semiconductor memory device, in general. Some examples conforming to this purpose are described briefly in the following.

As previously described, a potential difference of 0.8 volt is provided between the high potential side word lines $WL_+$ and the associated low potential side word line $WL_-$, whether the word lines are in selected state or non-selected state.

The potential on the word line $WL_+$ in selected state in each memory device is given as follows :
In the memory devices shown in Figs. 3 and 4,

$$V_{WL+} = V_{CC} - 0.8 \text{ (volts)} \dots\dots\dots\dots\dots \text{ (4)}$$

and in the memory device shown in Fig. 5,

$$V_{WL+} = V_{CC} - 1.6 \text{ (volts)} \dots\dots\dots\dots\dots \text{ (5)}$$

where $V_{WL+}$ designates the potential on the word line $WL_+$ in selected state.

The potential difference between the word lines in selected state and non-selected state, namely, the amplitude of the word line potential is given as

$$V_{WL+} - V'_{WL+} = 0.8 + \Delta V_{BE} + \delta \text{ (volts)} \dots \text{(6)}$$

where $V'_{WL+}$ denotes the potential on the word line $WL_+$ in non-selected state, while the 0.8 volt corresponds to the potential difference between the word lines $WL_+$ and $WL_-$, and $\Delta V_{BE}$ and $\delta$ are respectively the aforementioned base-emitter voltage difference and word line potential dispersion due to the nonuniformity of the value of the resistors R1, as explained with reference to Fig. 2.

Each of the reference voltages $V_{R2}$ and $V_{R3}$ is set higher by 0.8 volt than $V'_{WL+}$; consequently,

$$V_{R2} = V_{CC} - 0.8 - \Delta V_{BE} - \delta \text{ (volts)} \dots\dots\dots \text{ (7)}$$
$$V_{R3} = VCC - 1.6 - \Delta V_{BE} - \delta \text{ (volts)} \dots\dots\dots \text{ (8)}$$

Thus, reference voltage $V_{R2}$ or $V_{R3}$ is at a level lower than $V_{CC}$ by the sum of $\Delta V_{BE}$, $\delta$ and a multiple of 0.8 volt.

As previously pointed out with reference to Fig. 2, in a conventional bipolar static memory device, it is required that $\Delta V_{BE} + \delta \geqq 0.5$ (volt). However, according to the present invention, $\delta = 0$, hence it is enough to set the reference voltage $V_{R2}$ or $V_{R3}$ at the following levels :

$$V_{R2} = V_{CC} - 0.8 - \Delta V_{BE} \text{ (volts)} \ldots\ldots\ldots\ldots \text{(7')}$$
$$V_{R3} = V_{CC} - 1.6 - \Delta V_{BE} \text{ (volts)} \ldots\ldots\ldots\ldots \text{(8')}$$

A potential lower by 0.8 volt with respect to $V_{CC}$ can be obtained by using a memory cell constitutive of the bipolar static memory device. Some examples of such memory cell will be given in the following.

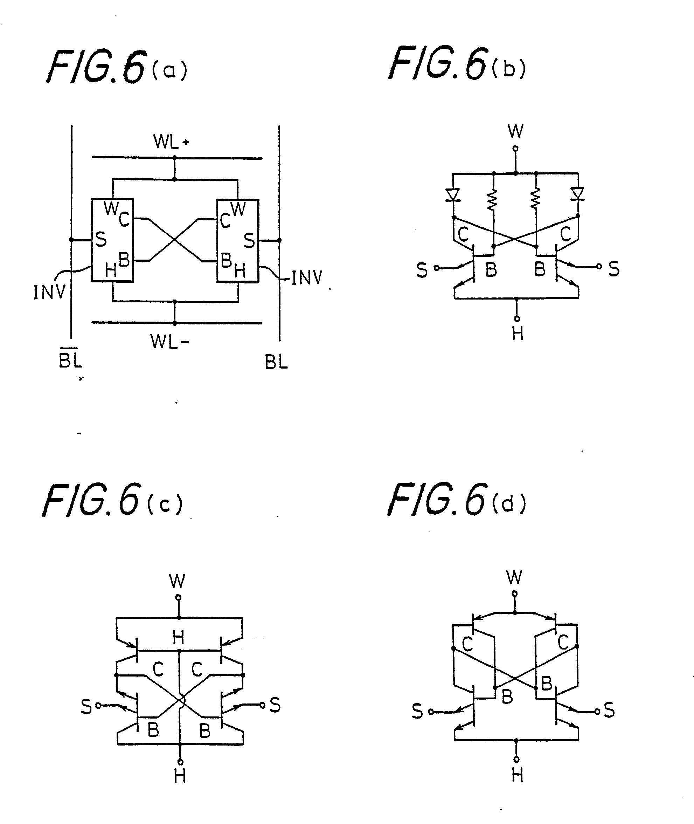

Fig. 5(a) is a conceptual block diagram showing the configuration of an ordinary static memory cell, which comprises a flip-flop circuit formed from two inverters INV which are cross-coupled to each other. Figs. 6(b), 6(c) are circuit diagrams each showing an exemplary detailed configuration of a conventional bipolar static memory cell.

Referring to Fig. 5(b), each of the inverters comprises a multi-emitter transistor, a diode and a resistor, wherein the base B and the collector C of the multi-emitter transistor in each inverter are respectively connected to the collector C and the base B of the multi-emitter transistor of the other inverter. One of the emitters of each multi-emitter transistor is commonly connected to a terminal H and linked to a holding-current source (not shown in Fig. 6 (b), but shown as IS2 in Fig. 3, 4 or 5) via a low potential side word line WL$_-$ (not shown), while another emitter of each multi-emitter transistor is connected to a bit line $\overline{BL}$ or BL (not shown) via a terminal S. The anode of each diode whose cathode is connected to the collector of the associated multi-emitter transistor is connected to a high potential side word line WL$_+$ (not shown) via a common terminal W together with the resistor whose one end is connected to the base of the associated multi-emitter transistor.

The memory cell shown in Fig. 6(c) comprises two $I^2L$ transistors, wherein each inverter is formed from a multi-emitter transistor and a pnpn transistor. The memory cell shown in Fig. 6(d) is a pnpn type cell, wherein each inverter is formed from a multi-emitter transistor and a pnpn transistor, as in the memory cell shown in Fig. 6(c), but the interconnection among the transistors is different.

When the memory cell shown in Fig. 6(b), for example, is in steady state, the potential difference ($V_F$) between the base of a multi-emitter transistor in OFF state and that of the multi-emitter transistor in ON state is 0.8 volt, and this potential difference $V_F$ is equal to the potential drop across the diode connected to the multi-emitter transistor in ON state. Thus, the potential at the node C connected to the multi-emitter transistor in ON state is lower by 0.8 volt with respect to the potential at the terminal W.

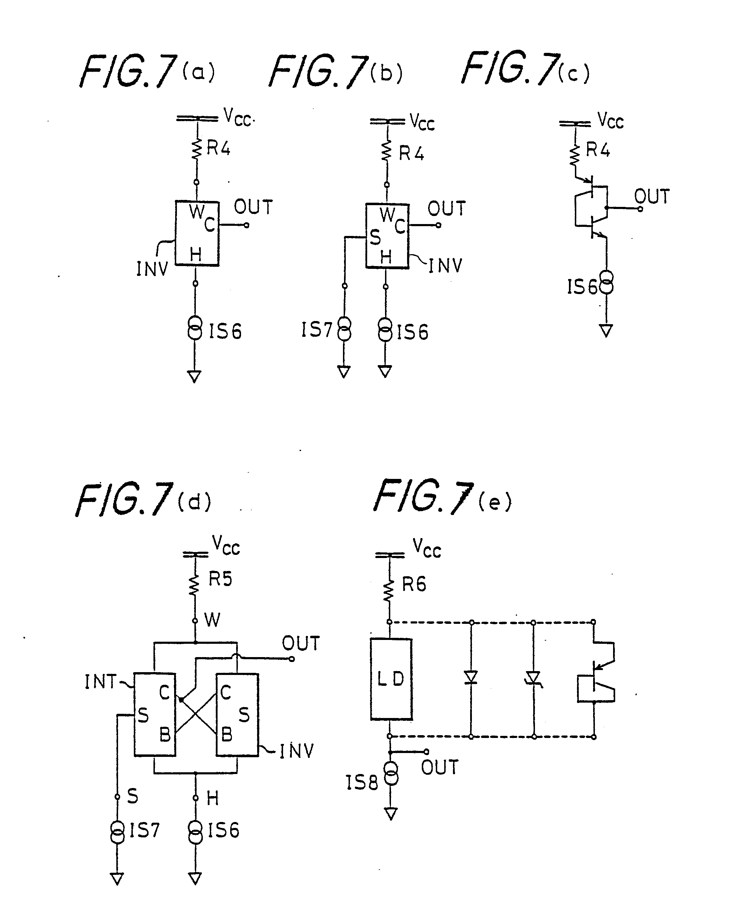

Figs. 7(a) to 7(e) are circuit diagrams showing exemplary reference voltage generation circuits formed from the above examples of memory cells. In the circuit shown in Fig. 7 (a) which comprises an inverter INV of the memory cell as shown in Figs. 6(b) to 6(d), the potential difference between the nodes W and C is $V_F$ (0.8 volt). A resistor R4 is inserted between $V_{CC}$ and W for providing a potential difference corresponding to $\Delta V_{BE}$, which potential difference is determined by the value of R4 and the current regulated by a constant current circuit IS6. Accordingly, a voltage lower by the sum of $V_F$ and $\Delta V_{BE}$ with respect to $V_{CC}$ is available at a terminal OUT connected to the node C.

The circuit shown in Fig. 7(b) differs from the one of Fig. 7(b) in that the terminal S of the inverter INV, which is linked to an emitter of the multi-emitter transistor other than the emitter connected to the terminal H, is connected to a different constant current circuit IS7. The constant current circuit IS6 is for supplying the current corresponding to the holding current in a memory cell, while the constant current circuit IS7 is responsible for the current corresponding to the read-out current of a memory cell.

The circuit shown in Fig. 7(c) is an embodiment of Fig. 7(a) and is formed from an inverter constitutive of a pnpn type memory cell as shown in Fig. 6(d). The circuit shown in Fig. 7(d) is formed from a dummy cell equivalent to an actual memory cell as shown in Figs. 5(b) to 6(d), comprising two inverters, and has improved temperature characteristic compared to the preceding circuits shown in Figs. 7(a) to 7(c). Terminal W is connected to $V_{CC}$ through a resistor R5 and terminals H and S are connected to constant current circuits IS6 and IS7. The circuit shown in Fig. 7(e) is formed only from the components which are used as the load LD in the memory cells as shown in Figs. 6(b) to 6(d). The load components LD employable include a diode, a Schottky barrier diode and a pnp transistor, as shown in Fig. 7(e). In Fig. 7(e), LD has one terminal connected to $V_{CC}$ through a resistor R6 and the other terminal connected to a constant current circuit IS8.

Although $V_{R2}$ (which is lower by the sum of 0.8 volt and $\Delta V_{BE}$ with respect to $V_{CC}$) can be obtained by the circuits shown in Figs. 7(a) to 7(e), $V_{R3}$ (which is lower by the sum of 1.6 volts and $\Delta V_{BE}$ with respect to $V_{CC}$) must be further lowered than $V_{R2}$ by 0.8 volt. This can simply be accomplished by adding a diode or transistor to the circuits of Figs. 7(a) to 7(b). That is, for each circuit shown in Figs. 7(a), 7(b) and 7(d), a diode is inserted between the resistor R4 or R5 and the terminal W in the forward direction, and for the circuit shown in Fig. 7(c), a diode is inserted between the resistor R4 and the emitter of the pnpntransistor in the forward direction, for example. In the case of the circuit shown in 7(e), a diode can be inserted between the resistor R6 and the load component LD in the forward direction. Thus, a potential $V_{R3}$ lower than $V_{R2}$ by 0.8 volt can be obtained. An embodiment of a circuit providing the additional lowering of the level of 0.8 volts by applying the above principles is shown in Fig. 8(a), this circuit differing from the one shown in Fig. 7(a) by the addition of a diode D2 serially connected with R4 between $V_{CC}$ and the node W.

The additional 0.8 volt drop can also be obtained by adding a transistor to the circuits shown in Figs. 7(a) to 7(e) instead of the addition of diode as described above. Fig. 8(b) is a circuit diagram showing an application of this method to the circuit shown in Fig. 7(d). A transistor Q7 is connected through its base to the terminal OUT supplying $V_{R2}$. The collector and the emitter of the transistor Q7 are respectively connected to the positive potential source $V_{CC}$ and a constant current circuit IS9. Thus, a potential lower than $V_{R2}$ by 0.8 volt is supplied from a terminal OUT2 connected to the emitter of the transistor Q7. A same additional transistor can be provided for each one of the other circuits shown in Figs. 7(a) to 7(e) in order to obtain a potential $V_{R3}$ lower than $V_{R2}$ by 0.8 volt.

## CLAIMS

1. A semiconductor memory device comprising :

a plurality of memory cells (MC);

a plurality of word lines ($WL_+$, $WL_-$) each connected to said memory cells; and

a plurality of word line selecting circuits (20;21; 22), each connected to a respective one of said word lines and providing the associated word line with a predetermined selection potential when the associated word line is selected;

characterized by :

a plurality of clamping circuits (Q6; Q5, R3), each connected to a respective one of said word lines and maintaining the potential on the associated said word line ($WL_+$) at a predetermined deselect level when said associated word line is in non-selected state.

2. A semiconductor memory device according to claim 1, characterized in that said memory device further comprises a voltage source ($V_{R2}$) which is common to said plurality of clamping circuits (Q6) and provides a reference voltage to each one of said clamping circuits.

3. A semiconductor memory device according to claim 2, characterized in that each one of said clamping circuits comprises an npn transistor (Q6) having a base connected to said voltage source ($V_{R2}$) and an emitter connected to said word line ($WL_+$).

4. A semiconductor memory device according to claim 1, characterized in that each one of said word line selecting circuits (20,21) includes a word driver gate (Q1,Q2;Q7,Q8) and a word driver transistor (Q3) having a base connected to said word driver gate and an emitter connected to associated said word line.

5. A semiconductor memory device according to claim 1, characterized in that each one of said word line selecting circuits (22) comprises a pair of transistors (Q4,Q5) connected to each other in Darlington coupling mode.

6.    A semiconductor memory device according to claim 4, characterized in that said word driver gate comprises a gate (Q7, Q8) other than an emitter coupled logic gate.

7.    A semiconductor memory device according to claim 6, characterized in that said word driver gate comprises a CMOS inverter (Q7, Q8).

# FIG.1

## PRIOR ART

# FIG.2(a)

SELECT MODE

DESELECT MODE

-0.8V WL+
100
Q101
-1.6V WL-
-2.1V WL+
200
Q201
-2.9V WL-

$\overline{BL}$    BL

FIG.2(b)

FIG.8(a)

FIG.8(b)

FIG.3

FIG.4

# FIG.5

# FIG.6 (a)

# FIG.6 (b)

# FIG.6 (c)

# FIG.6 (d)

0140768

7/7

FIG.7(a)  FIG.7(b)  FIG.7(c)

FIG.7(d)  FIG.7(e)